(19) Europäisches Patentamt

European Patent Office

Office européen des brevets

(11) EP 3 637 138 A1

(12) **EUROPEAN PATENT APPLICATION**

(43) Date of publication:
**15.04.2020 Bulletin 2020/16**

(21) Application number: **18199899.8**

(22) Date of filing: **11.10.2018**

(51) Int Cl.:
*G01S 17/00* (2020.01)     *G06F 17/50* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Industry Software and Services B.V.**
**2289 CC Rijswijk (NL)**

(72) Inventor: **PHILLIPS, Michael**
**2564 HH The Hague (NL)**

(74) Representative: **Maier, Daniel Oliver et al**
**Siemens AG**
**Postfach 22 16 34**
**80506 München (DE)**

(54) **SIMULATION OF LIGHT DETECTION AND RANGING BEAMS**

(57)     The present invention is related to a method of simulating a LIght Detection And Ranging (LIDAR) beam. In particular, the present invention is related to simulating a LIDAR beam through ray-tracing. A respective method (10) of simulating a LIDAR beam (30) of a LIDAR sensor in a scene, comprises in particular the steps:
- Finding (15) an intersection of the current ray (33, 51) with an object (50) of the scene through ray-tracing.
- Determining (16.1) a reflected energy (52, 53) of the current ray (33, 51).
- Determining (16.5) a scattered ray (51) based on the current ray (33, 51) scattered from the object (50) at the intersection.
- Continuing (16.6) the iteration for the scattered ray (51).

FIG 5

EP 3 637 138 A1

**Description**

The present invention is related to a method of simulating a LIght Detection And Ranging (LIDAR) beam. In particular, the present invention is related to simulating a LIDAR beam through ray-tracing.

LIDAR is an optical method for measuring distance and velocity as well as for measuring atmospheric parameters. Laser rays or beams of several rays are used for the measuring.

LIDAR is used as a measuring instrument for stationary and mobile speed monitoring. In the field of construction and surveying LIDAR is used for distance measuring. Further, in Automatic Driver Assistance Systems (ADAS), and in autonomous vehicles, LIDAR is used for both measuring distance, e.g. to detect objects in the surroundings of a vehicle and to create a virtual map of said surroundings, and measuring velocity, e.g. to implement a collision warning. Moreover, in the field of aviation, LIDAR is also used for detecting turbulences and wind shear. Consequently, the measurements done with LIDAR must be reliable and precise because critical decisions are based thereon.

In order to improve the reliability and precision of a LIDAR system configuration, testing and validation is aided with simulations of the respective LIDAR system. Thereto, High-quality, physics based simulations of LIDAR systems are needed. For such high-quality, physics based simulations it is necessary to accurately simulate a LIDAR beam, to produce data which is as close as possible to real data.

It is known to simulate ideal point clouds with a single simulated ray, e.g. by ray-tracing up to the nearest intersection point with a surface, whereby only mirror-reflection is considered such that only one distance per ray is computed. Here, the single ray or sub-beams of a beam represented by single rays are emitted from one point (one point source). Such simulation returns only point data and neither the beam nor the resulting signal is simulated. Further it is known, to simulate a LIDAR beam with a 2D tree canopy in a 2D grid using a probability map to determine how the light propagates (light is propagated through probability), whereby Lambertian or mirror reflection can be considered. Here, many rays are needed to sufficiently simulate the LIDAR beam and still the simulation is limited to 2D only. Thereby, each of the rays updates a signal of the beam only at a single time point. So, many iterations of the simulation of one beam are averaged together for each beam. However, no multiple interactions of the whole beam (several rays) with the environment (e.g. scattering of a ray on several surfaces) and no energy distribution of the ray along its cross-section are considered. Interaction between two or more subsequent beams is not considered.

Consequently, there is a need for a method of simulating a LIDAR beam that simulates all aspects and interactions with the environment of a LIDAR beam as precise as possible.

These objectives are achieved by the Method according to claim 1 and the apparatus according to the further independent claim. Further refinements of the present invention are subject of the dependent claims.

According to a first aspect of the present invention a method of simulating a LIght Detection And Ranging (LIDAR) beam of a LIDAR sensor in a scene comprises the following sequential steps:

     a) Discretising a source area of the LIDAR beam into separate origins.
     b) Selecting rays based on the origins.
     c) The method further comprises the following sequential steps for each ray:

         c1) Finding an intersection of the current ray with an object of the scene through ray-tracing.
         c2) The method further comprises the following steps if an intersection is found:

         - Determining a reflected energy of the current ray that is reflected from the object at the intersection back to the LIDAR sensor.
         - Adding the reflected energy to a signal.
         - Determining a scattered ray based on the current ray scattered from the object at the intersection.
         - Continuing with step c1) for the scattered ray.

         c3) Continuing with step c1) for the next ray.

     d) Storing and/or outputting the added up signal. According to a second aspect of the present invention a system for simulating a LIDAR beam of a LIDAR sensor in a scene is configured for implementing the method according to the first aspect and comprises a processing unit and a storage. The processing unit has a discretising module, a selecting module and a ray-tracing module. The discretising module is configured for discretising a source area of the LIDAR beam into separate origins. The selecting module is configured for selecting rays based on the origins. The ray-tracing module is configured for:

     - Finding an intersection of the current ray with an object of the scene through ray-tracing for each ray.
     - Determining a reflected energy of the current ray that is reflected from the object at the intersection back to the LIDAR sensor if an intersection is found.
     - Adding the reflected energy to a signal if an intersection is found.
     - Determining a scattered ray based on the current ray scattered from the object at the intersection if an intersection is found.
     - Continuing with finding an intersection for the scattered ray.
- Continuing with finding an intersection for the next ray.

The storage is configured for storing the added up signal or an output configured for outputting the added up signal.

A LIDAR beam is characterised by several parameters: e.g. the beam cross-section, the beam divergence, the beam emission pattern and the beam pulse pattern. A LIDAR beam commonly used in automotive has a rectangular or square cross-section within which a laser or multiple lasers have a emission pattern comprising horizontal or vertical rows/stripes or any other suitable pattern including meander shapes, circles, ellipses, spirals, a Gaussian configuration and the like. The beam may originate from a point source or several point sources defining a source area. From the point source or the source area the beam diverges with a certain divergence angle or divergence angles, which may be measured relative to the emission direction of the point source or source area, respectively. If the LIDAR beam is emitted by a point source, the beam has a certain initial source area some distance away from the actual point source. In order to be able to use the method for single laser and multi laser LIDAR beam simulation the beam is always simulated starting from a source area.

In the first step a) the source area is discretised into separate origins. The source area may be discretised into 100.000 or less, preferably 10.000 or less and most preferably 4000 or less origins. Each origin can be the origin of one single ray of the LIDAR beam. Each ray has a certain emitting direction such that the LIDAR beam is simulated as a truncated pyramid of arbitrary cross-sectional shape like a frustum originating at the source area and diverging with a certain angle of divergence from the emission direction of the source area. The direction of each ray may be characterised by two divergence angles, $\theta$ and $\varphi$. The two divergence angles may each be within one of two perpendicular planes spanned by the emission direction and a respective radial direction perpendicular to the emission direction.

In the second step b) rays are selected based on the origins. Each of the origins may emit one single ray of the LIDAR beam that is simulated as a truncated pyramid of arbitrary cross-sectional shape (e.g. frustum). Thereby, each ray has a certain direction along which the ray radiates from the source area. The number of rays, that is selected based on the respective origins, may be deliberately predetermined. Consequently, only a subset of the whole LIDAR beam is selected. However, increasing the number of rays also increases the precision of the simulation results. The rays may be selected according to a certain pattern or rule or randomly.

Each of the selected rays is simulated propagating through the scene or environment and interacting with the objects in the scene.

In the first step c1) for each of the rays an intersection of the current ray with an object in the scene is found by means of ray-tracing. Ray-tracing is a method to sample geometry in a virtual scene known from computer graphics. In computer graphics, ray-tracing is used to create an image by shooting rays from a camera and instantaneously (no propagation time) accumulate light on a sensor pixel. In the present method the selected rays (of the laser) are shot originating from the respective origin of the source area and connected to the LIDAR sensor, where light energy is accumulated in the (time varying) signal. In contrast to the ray-tracing used in computer graphics, ray-tracing in the present invention does not ignore propagation time of the rays.

If an intersection is found for the current ray in step c1), then in the second step c2) for each of the rays the reflected energy of the (originally emitted) ray and its scattered ray are determined. At the intersection with an object the current ray interacts with the surface of the object. One part of the energy of the current ray is reflected back towards the LIDAR sensor as the reflected energy. The amount of energy that is reflected back depends on a material and surface of the object. The interactions with the objects in the scene may be calculated based on radiance rather than energy with the Bidirectional Scattering Distribution Function (BSDF). If the BSDF is used, the radiance is only converted into the unit of energy when the reflected energy is added to the signal. Apart from that all interactions between the rays and objects are calculated in the unit of radiance. Further, the remaining energy of the current ray is scattered into a different direction with a certain scattering angle that depends on the material and surface of the object. The reflected energy is added to the signal, representing the signal of the real LIDAR sensor, and the scattered ray is continued to be simulated. So, instead of continuing with the next ray of the LIDAR beam, the scattered ray is ray-traced through the scene, by continuing with step c1) for the scattered ray. If an intersection of the scattered ray with an object in the scene is found during the continued ray-tracing, again the reflected energy is determined, this time based on the scattered ray, and added to the signal. There may be a check whether the reflected energy can propagate from the intersection to the (virtual) LIDAR sensor without any occlusion. Thereto, via a shadow ray the visibility of the respective intersection from the view point of the (virtual) LIDAR sensor is checked, wherein the shadow ray is cast from the (virtual) LIDAR sensor to the respective intersection. The scattered ray (which is the current ray in this iteration) is also scattered such that a (twofold) scattered ray is continued to be simulated. Accordingly step c1) is executed for the newly (twofold) scattered ray. The ray-tracing for scattered rays continues as long as an intersection at the surface of an object in the scene occurs for the scattered rays. In order to avoid tracing a ray to infinity, a lower threshold for the energy of the scattered ray down to which it is simulated and/or a maximal number of reflections/bounces (e.g. 10 reflections) can be predefined.

If no (more) intersection of a current ray (originally emitted ray or scattered ray, respectively) occurs during ray-tracing in step c1) then according to step c3) for each of the rays, the next ray is ray-traced in step c1). Consequently, each of the selected rays is ray-traced and, if an intersection is found, scattered and, in turn, the resulting scattered ray is traced until no more intersection with an object in the scene occurs or optionally until the lower threshold for the energy of the ray or the maximal number of reflections is reached. At each intersection the reflected energy based on the current ray (originally emitted ray or scattered ray, respectively) is added to the signal of the LIDAR sensor.

After all rays are simulated in steps c1) to c3) the resulting signal containing the summed up reflected energies is outputted to another method or system or a user. The signal can alternatively or additionally be stored in a storage device.

With the present method arbitrary 3D geometry can be simulated, where real intersection points are found, and multiple bounces of the rays of the beam (multi-bounce rays) are considered and the reflected energy of each ray and also of any of its resulting scattered rays are added to the signal. This enables a more precise simulation of the actual signal of the real LIDAR sensor because all interactions of the beam and its scattered rays with the environment (object in the scene) are simulated. Further, only one simulation per LIDAR beam is necessary to simulate every single possible interaction of the rays of the beam with the environment. Consequently, LIDAR systems can be configured with better tolerance and be tested and validated with higher precision. This adds to security for example in autonomous vehicles and ADAS systems for modern vehicles.

According to a refinement of the present invention in step b) the rays are randomly selected.

Based on a randomly selected number of rays, which represent the whole LIDAR beam, the physics of the interactions can be simulated with Monte-Carlo Integration (randomised quadrature or Crude Monte-Carlo Integration).

This enables a precise and reliable simulation of the whole LIDAR beam based on only a few rays. Thus, the computing time and effort can be significantly reduced.

According to a refinement of the present invention in step b) the rays are randomly selected based on at least one random number and preferably based on two random numbers.

The selection of rays used for the simulation of the LIDAR beam can be effected with the help of one single random number. For example the origins of the discretised surface area can be consecutively numbered and the rays can be selected by randomly choosing numbers of the origins. Further, the selection of rays can be based on two random numbers. For example two random numbers each for one of the two deflection angles can be randomly chosen or the origins can be numbered according to their position in a x direction (dim x) and a perpendicular y direction (dim y) and the origins of the rays can be randomly chosen based on these two dimensions.

Selecting the rays based on one or two random numbers is a very efficient way of determining the set of rays used for simulation of the LIDAR beam.

According to a refinement of the present invention in step b) the rays are randomly selected by importance sampling, low discrepancy sampling patterns or deterministic sampling patterns.

Importance sampling is a general technique for estimating properties of the LIDAR beam, while only having samples generated from a different distribution namely the selected rays than the distribution of interest namely the whole beam. Low-discrepancy sampling patterns are quasi-random or sub-random patterns, due to their use as a replacement of uniformly distributed random numbers for choosing the rays. In quasi-Monte-Carlo method the lower discrepancy of the low-discrepancy sampling patterns is an important advantage. Despite the deterministic character of deterministic sampling patterns, the latter can be used instead of a random selection scheme and nevertheless produce a suitably distributed selection of rays just like the random schemes mentioned before.

By using importance sampling, low discrepancy sampling patterns or deterministic sampling patterns the computing time and effort can be further reduced.

According to a refinement of the present invention in step b) at least two, preferably at least 100, more preferably at least 500 and most preferably at least 1000 rays are selected.

According to a refinement of the present invention in step b) at most 100000, preferably at most 10000, more preferably at most 5000 and most preferably at most 2000 rays are selected.

The more rays are selected for simulating the whole LIDAR beam, the more precise and reliable are the simulation results, namely the signal.

With ray-tracing a limited number of rays as subset of the whole LIDAR beam, the computing time and effort can be significantly reduced while maintaining a sufficiently high precision and reliability of the simulation results. According to a refinement of the present invention step c2) further comprises the following steps if an intersection is found:

- Calculating an intersection time point $t_I$ based on a radiation time point $t_R$ of the current ray and on a length of the current ray from its origin to the intersection $s_I$.
- Calculating a sensing time point ts of sensing the reflected energy at the LIDAR sensor based on the intersection time point $t_I$ and on the length of a distance from the intersection to the LIDAR sensor.

In the step of adding the reflected energy, the reflected energy is added to the signal at the sensing time point ts.

If an intersection of the current ray (originally emitted ray or scattered ray, respectively) is detected in step c1) the total length of the current ray from the respective origin to the intersection or the total length of the scattered ray from the respective origin to the last intersection (along all preceding intersections) $s_I$ is used together with the speed of light c to calculate the travel time of the respective ray. The respective intersection time point $t_I$ is then calculated based on the time point of radiation $t_R$, which is the time point, when the respective ray was emitted from the source area.

$$t_I = t_R + \frac{s_I}{c}$$

The sensing time point ts when the reflected energy is sensed at the LIDAR sensor is calculated based on the intersection time point $t_I$ and the length between the intersection and the LIDAR sensor $s_S$, wherein the length of path along which the reflected energy travels from the intersection to the LIDAR sensor is also determined by ray-tracing.

$$t_S = t_I + \frac{s_S}{c}$$

Based on the determined sensing time point ts the reflected energy is added to the signal at said sensing time point ts.

Tracing the total length of the ray and the length of the path of the reflected energy and calculating the respective time points for the rays and the resulting signal based on the different lengths is very efficient and thus reduces the computing effort.

According to a refinement of the present invention step of determining a scattered ray comprises reducing the current ray by the reflected energy.

In case an intersection with an object in the scene is found in step c1), the current ray or the scattered ray, respectively is reduced by the determined reflected energy that is reflected back to the LIDAR sensor from the surface of the object. The interactions between the current ray (originally emitted ray or scattered ray, respectively) and the objects in the scene may be calculated using the BSDF, using the unit of radiance rather than the unit of energy. Thus, the current ray may be "continued" in the scattered direction reduced by the reflected energy.

This provides a way of tracing the rays with explicitly low implementation effort. Thus, the complexity and computing effort are further reduced.

According to a refinement of the present invention each ray represents a time varying energy distribution of a laser pulse contained in a vector of time bins and the reflected energy represents a time varying energy distribution corresponding to the energy of the laser pulse reflected from the object at the intersection back over time contained in a vector of time bins.

The rays originating from the source area are simulated with a time varying energy distribution. The energy distribution is modelled as the time based energy distribution of a laser pulse. This energy distribution is contained in a vector of time bins, where every time bin contains a certain energy value of the ray. The time bins may have a size of about 1 ps [Picosecond] to about 1 ns [Nanosecond], preferably of about 1 ps, more preferably of about 10 ps and most preferably of about 100 ps. The reflected energy represents a time varying energy distribution. The energy distribution of the reflected energy corresponds to the energy (or radiance) of the laser pulse that is reflected from the surface object at the intersection. The reflected energy (distribution) is sent back to the (virtual) LIDAR sensor where it is sensed over time. Additionally, there may be a check whether the path along which the reflected energy travels from the intersection to the (virtual) LIDAR sensor is not blocked or occluded by an object or other occlusion. In other words, the visibility of the intersection from the view point of the (virtual) LIDAR sensor is determined with a shadow ray cast from the (virtual) LIDAR sensor to the respective intersection. The energy distribution of the reflected energy is contained in a vector of time bins. The time bins may have a size of about 1 ps to about 1 ns, preferably of about 1 ps, more preferably of about 10 ps and most preferably of about 100 ps.

With the present refinement the energy distribution of the LIDAR beam with all its rays is considered in the simulation such that a full physics based simulation is enabled, where the LIDAR beam is fully simulated. Thus, arbitrary material properties can be used in the simulation and a full-waveform signal is computed. This enables a more precise simulation of the actual signal of the real LIDAR sensor because all interactions of the beam and its scattered rays with the environment (objects in the scene) are simulated. Consequently, LIDAR systems can be configured with better tolerance and be tested and validated with higher precision. This adds to security for example in autonomous vehicles and ADAS systems for modern vehicles.

According to a refinement of the present invention the signal is distributed over time represented by a vector of time bins. The vector has a length corresponding to a predetermined sampling time $T_S$.

The rays have an energy that is represented as a time varying energy distribution which is contained in a vector of time bins. To be able to map the energy distributions of all the reflected energies which are accordingly represented by vectors of time bins the signal is represented by a vector with a length corresponding to the sampling time Ts. The sampling time Ts can be about 100 ns to 50000 ns and preferably about 500 ns to 2000 ns. The time bins may have a size of about 1 ps [Picosecond] to about 1 ns [Nanosecond], preferably of about 1 ps, more preferably of about 10 ps and most preferably of about 100 ps. The energy distributions of the reflected energies are sampled at the time point when they hit the LIDAR sensor and added bin-wise to the signal.

By sampling each energy distribution at the time point when the reflected energy is detected with the (virtual) LIDAR sensor a full physics based, full-waveform signal is calculated that precisely represents the real signal. Consequently, LIDAR systems can be configured with high precision and also be tested and validated against a highly accurate simulated signal.

According to a refinement of the present invention the reflected energies of precedent beams are accounted for in the present beam.

Due to very late reflection of a ray or a (multiply) scattered ray of a preceding beam its respective reflected energy may arrive at the (virtual) LIDAR sensor after the time point on which the simulation for the preceding beam ended. This "belated" reflected energy is not disregarded but accounted for in the signal of the simulation of the present beam.

With this accounting for reflected energies of preceding beams the simulation considers even "artefacts" from preceding beams. Therefore, "auxiliary" noise that is commonly used to account for such artefacts can be omitted. Consequently, an even more precise simulation of the signal of the LIDAR sensor is provided.

The processing unit may be controlled by a program implementing the method as described above.

The present invention and its technical field are subsequently explained in further detail by an exemplary embodiment shown in the drawing. The exemplary embodiment only conduces better understanding of the present invention and in no case is to be construed as limiting for the scope of the present invention. Particularly, it is possible to extract aspects of the subject-matter described in the figure and to combine it with other components and findings of the present description or figure, if not explicitly described differently. Equal reference signs refer to the same objects, such that explanations from other figures may be supplementary used.

Fig. 1     schematically shows a flow chart of a method according to the first aspect of the present invention.

Fig. 2     schematically shows a system according to the second aspect of the present invention.

Fig. 3     schematically shows a LIDAR beam.

Fig. 4     schematically shows a vector of a reflected energy and a vector of a signal of a LIDAR sensor.

Fig. 5     schematically shows multi-bounce ray-tracing.

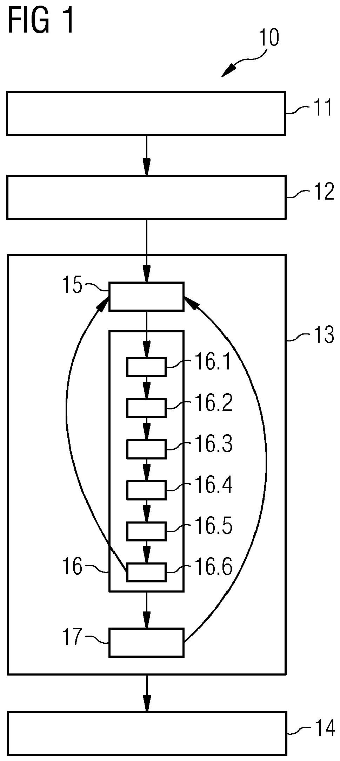

In Fig. 1 a flow chart of a method 10 of simulating a LIght Detection And Ranging (LIDAR) beam of a LIDAR sensor in a scene is schematically depicted. The method comprises a first step a) of discretising 11 a source area, a subsequent second step b) of selecting 12 rays, a subsequent third iteration step c) for ray-tracing 13 and a fourth step of storing and/or outputting 14. The third iteration step c) for ray-tracing 13 comprises a first step c1) of finding 15 an intersection, a subsequent second iteration step c2) for signal calculation 16 and a third step c3) of continuing 17 with step c1). The second iteration step c2) for signal calculation comprises a step of determining 16.1 a reflected energy, a step of calculating 16.2 an intersection time point $t_I$, a step of calculating 16.3 a sensing time point $t_S$, a step of adding 16.4 the reflected energy, a step of determining 16.5 a scattered ray and a step of continuing 16.6 with step c1).

The source area of the LIDAR beam is discretised into origins in the first step a) of discretising 11. Each origin is the basis from which one single ray of the LIADR beam is emitted in a specific direction. The direction is given by two divergence angles $\varphi$ and $\theta$ measured against the emission direction on the source area.

Based on one or two random numbers 2 to 100000, preferably 100 to 10000, more preferably 500 to 5000 and most preferably 1000 to 2000 rays are selected in the second step b) of selecting 12. The selecting 12 is based on importance sampling, low discrepancy sampling patterns or deterministic sampling patterns. Each ray represents a time varying energy distribution of a laser pulse. The energy distribution of the laser pulse is simulated as a normal distribution contained in a vector of time bins. The time bins have a size of 100 ps [Picoseconds]. The vector of the ray has a total length of 10 ns [Nanoseconds] containing 100 bins.

In the following third iteration step c) for ray-tracing 13 each of the (originally emitted) rays or scattered rays (see below) is traced and an intersection with an object in a virtual scene is searched according to the first step c1) of finding 15. If an intersection is found the second iteration step c2) for signal calculation 16 is executed.

Based on the found intersection with a surface of the object a reflected energy is determined based on the material and surface of the object in the step of determining 16.1 for the current ray or the scattered ray (see below). The reflected energy represents a time varying energy distribution of the reflected energy corresponding to the energy of the laser pulse that is reflected from the surface object at the intersection. The reflected energy (distribution) is sent back to the (virtual) LIDAR sensor where it is sensed over time. The energy distribution of the reflected energy is contained in a vector of time bins. The time bins have a size of 100 ps and the vector of the reflected energy has a total length of 10 ns containing 100 bins. The reflected energy is added to the signal representing the signal of the real LIDAR sensor.

Further an intersection time point $t_I$ is calculated in the step of calculating 16.2 based on a radiation time point $t_R$ of the respective ray, which is the time point, when the respective ray was emitted from the source area, and a total length of the current ray from the respective origin to the intersection or the total length of a scattered ray (see below) from the respective origin to the last intersection (along all preceding intersections) $s_l$ together with the speed of light c.

$$t_I = t_R + \frac{s_I}{c}$$

Further, in the step of calculating 16.3 a sensing time point ts, giving the time point when the reflected energy is sensed at the LIDAR sensor, is calculated based on the intersection time point $t_l$ and the length between the intersection and the LIDAR sensor $s_S$, wherein the length of path along which the reflected energy travels from the intersection to the LIDAR sensor is also determined by ray-tracing.

$$t_S = t_I + \frac{s_S}{c}$$

Based on the determined sensing time point ts the vector of the reflected energy (100 bins of 100 ps each) is added in the step of adding 16.4 to the signal at said sensing time point ts. The signal is distributed over time represented by a vector of time bins of 100 ps. The vector has a total length corresponding to a sampling time Ts of 700 ns and containing 7000 bins.

Additionally, in the step of determining 16.5 a scattered ray is determined based on the surface and material of the object at the intersection. The scattered ray has an energy distribution according to the ray but reduced by the scattered energy. The scattered ray leaves the intersection under a scattering angle depending on the surface and material of the object at the intersection.

If an intersection was found in step c1) of finding 15 the method 10 is continued in the step of continuing 16.6 at step c1) of finding 15 with the scattered ray as current ray.

If no intersection is found in step c1) of finding 15, then the method is continued in the step c3) of continuing 17 at step c1) of finding 15 with the next ray as current ray until all rays are processed.

After all rays have been processed the method is continued at the step d) of storing or outputting 14, where the added up signal is output to another method and/or system and/or to a user and/or stored in a storage.

Additionally to the reflected energies coming from the (originally emitted)rays and scattered rays of the present beam the method 10 may also consider reflected energies from (originally emitted) rays or scattered rays of preceding beams in the step of adding 16.5, when the reflected energy arrives at the (virtual) LIDAR sensor after the sampling time $T_S$. Thus, reflected energies that are not considered in the signal of the beam that effected the reflected energies because they arrive "belated" after the sampling time Ts can be considered in the signal of the next beam.

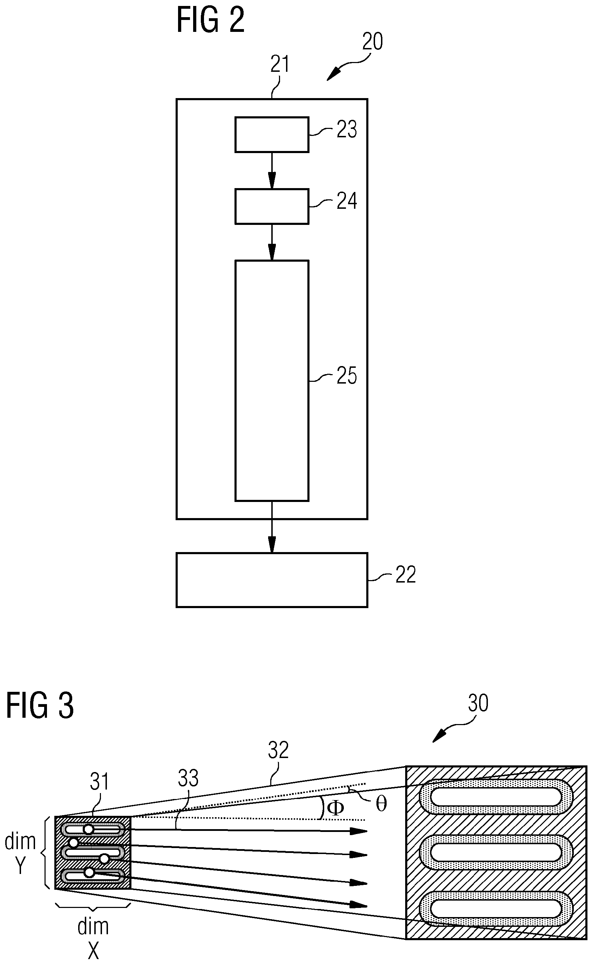

In Fig. 2 a system 20 for simulating a LIDAR beam of a LIDAR sensor in a scene is schematically depicted. The system 20 comprises a processing unit 21 and a storage and/or output 22. The processing unit has a discretising module 23 configured for discretising a source area of the LIDAR beam into separate origins, a selecting module 24 configured for selecting rays based on the origins, wherein each ray represents a time varying energy distribution of a laser pulse contained in a vector of time bins, and a ray-tracing module 25. The ray-tracing module 25 is configured for finding an intersection of the current ray with an object of the scene through ray-tracing for each ray. The ray-tracing module is further configured for determining a reflected energy of the current ray that is reflected from the object at the intersection back to the LIDAR sensor if an intersection is found, wherein the reflected energy represents a time varying energy distribution corresponding to the energy of the laser pulse reflected from the object at the intersection back over time contained in a vector of time bins. Also the ray-tracing module 25 is configured for calculating an intersection time point $t_l$ based on a radiation time point $t_R$ of the current ray and on a length of the current ray from its origin to the intersection $s_l$ and for calculating a sensing time point ts of sensing the reflected energy at the LIDAR sensor based on the intersection time point $t_l$ and on the length of a distance from the intersection to the LIDAR sensor $s_S$, wherein in the step of adding the reflected energy, the reflected energy is added to the signal at the sensing time point ts. Additionally, the ray-tracing module 25 is configured for adding the reflected energy to a signal if an intersection is found. Moreover, the ray-tracing module 25 is configured for determining a scattered ray based on the current ray scattered from the object at the intersection if an intersection is found and for reducing the current ray by the reflected energy as well as for continuing with finding an intersection of the current ray for the scattered ray. Lastly, the ray-tracing module is also configured for continuing with finding an intersection of the current ray for the next ray. The storage 22 is configured for storing the added up signal and the output 22 configured for outputting the added up signal.

The processing unit 21 can be a Central Processing Unit (CPU) or Graphics Processing Unit (GPU) like a Microcontroller (pC), an integrated circuit, an Application-Specific Integrated Circuit (ASIC), an Application-Specific Standard Product (ASSP), a Digital Signal Processor (DSP), a Field Programmable Gate Array (FPGA) and the like. The processing unit 21 may be controlled by a program implementing the method of Fig. 1 or as described above. The modules 23 to 25 may be part of the processing unit 21 or implemented on the processing unit 21 or separate units in communicative connection with the processing unit 21. The storage 22 can be a data storage like a magnetic storage/memory (e.g. magnetic-core memory, magnetic tape, magnetic card, magnet strip, magnet bubble storage, drum storage, hard disc drive, floppy disc or removable storage), an optical storage/memory (e.g. holographic memory, optical tape, Tesa tape, Laserdisc, Phasewriter (Phasewriter Dual, PD), Compact Disc (CD), Digital Video Disc (DVD), High Definition DVD (HD DVD), Blu-ray Disc (BD) or Ultra Density Optical (UDO)), a magneto-optical storage/memory (e.g. MiniDisc or Magneto-Optical Disk (MO-Disk)), a volatile semiconductor/solid state memory (e.g. Random Access Memory (RAM), Dynamic RAM (DRAM) or Static RAM

(SRAM)), a non-volatile semiconductor/solid state memory (e.g. Read Only Memory (ROM), Programmable ROM (PROM), Erasable PROM (EPROM), Electrically EPROM (EEPROM), Flash-EEPROM (e.g. USB-Stick), Ferroelectric RAM (FRAM), Magnetoresistive RAM (MRAM) or Phase-change RAM) or a data carrier/medium. The output 22 may be any kind of port or link or interface capable of communicating information to another (e.g. WLAN, Bluetooth, ZigBee, Profibus, ETHERNET etc.) system or to a user (Display, Printer, Speaker etc.).

In Fig. 3 a LIDAR beam 30 is schematically depicted. The LIDAR beam 30 has a rectangular source area 31 with a first dimension dim X and a second dimension dim Y. Here the source area 31 is a square with dim X = dim Y. The LIDAR beam is made up by three striped emission pattern of a single laser diode scanning the environment or scene. The LIDAR beam 30 has two divergence angles $\varphi$ and $\theta$, wherein here $\varphi = \theta$. Consequently, the LIDAR beam 30 has the shape of a frustum 32. The LIDAR beam 30 is made up by rays 33 originating from the source area 31 and each projecting from one origin of the source area 31 in a unique direction defined by $\varphi$ and $\theta$.

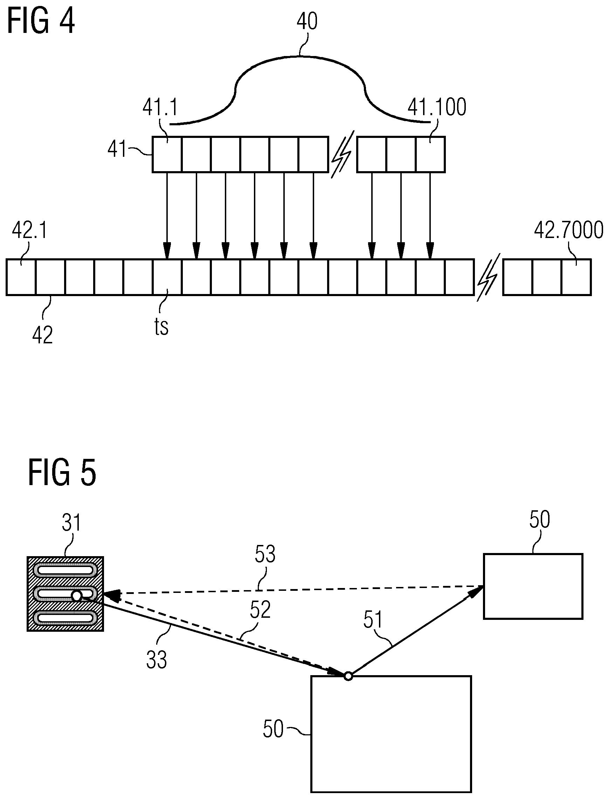

In Fig. 4 a vector of a reflected energy 41 and a vector of a signal 42 of a LIDAR sensor are schematically depicted. each ray of the LIDAR beam may be represented by an energy distribution. This energy distribution corresponds to an energy distribution of a laser pulse of a LIDAR sensor. The energy distribution of the laser pulse is simulated as a normal distribution. As the ray is scattered at an intersection with an object a part of its energy is reflected back to the LIDAR sensor as reflected energy. The energy distribution 40 of the reflected energy is also a normal distribution. At the sensing time point ts the reflected energy is added to the signal simply by adding the bins 41.i, i = 1..100, of the vector 41 of the reflected energy to the respective bins 42.j, j = 1..7000, of the vector 42 of the signal.

In Fig. 5 multi-bounce ray-tracing is schematically depicted. A ray 32 originating from the source area 31 is scattered at an object 50 one part of its energy is reflected back to the LIDAR sensor as reflected energy 52. The ray is also continued as scattered ray 51 reduced by the reflected energy 52. The scattered ray is scattered at another object 50 and part of the energy of the scattered ray 51 is reflected back to the LIDAR sensor as another reflected energy 53. This multi-bounce ray-tracing may be executed for any arbitrary number of scatterings of one ray 33.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

In the foregoing detailed description, various features are grouped together in one or more examples for the purpose of streamlining the disclosure. It is understood that the above description is intended to be illustrative, and not restrictive. It is intended to cover all alternatives, modifications and equivalents as may be included within the scope of the invention. Many other examples will be apparent to one skilled in the art upon reviewing the above specification.

Specific nomenclature used in the foregoing specification is used to provide a thorough understanding of the invention. However, it will be apparent to one skilled in the art in light of the specification provided herein that the specific details are not required in order to practice the invention. Thus, the foregoing descriptions of specific embodiments of the present invention are presented for purposes of illustration and description. They are not intended to be exhaustive or to limit the invention to the precise forms disclosed; obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. Throughout the specification, the terms "including" and "in which" are used as the plain-English equivalents of the respective terms "comprising" and "wherein," respectively. Moreover, the terms "first," "second," and "third," etc., are used merely as labels, and are not intended to impose numerical requirements on or to establish a certain ranking of importance of their objects. In the context of the present description and claims the conjunction "or" is to be understood as including ("and/or") and not exclusive ("either ... or").

**Claims**

1. Method (10) of simulating a LIght Detection And Ranging, LIDAR, beam (30) of a LIDAR sensor in a scene, comprising the following sequential steps:

   a) discretising (11) a source area (31) of the LIDAR beam (30) into separate origins;
   b) selecting (12) rays (33) based on the origins;
   c) comprising the following sequential steps (13) for each ray (33):

      c1) finding (15) an intersection of the current ray (33, 51) with an object (50) of the scene through ray-tracing;
      c2) comprising the following steps (16) if an intersection is found:

         - determining (16.1) a reflected energy (52, 53) of the current ray (33, 51) that is reflected from the object (50) at the intersection back to the LIDAR sensor;
         - adding (16.4) the reflected energy (52, 53) to a signal;
         - determining (16.5) a scattered ray (51) based on the current ray (33, 51) scattered from the object (50) at the intersection; and
         - continuing (16.6) with step c1) for the scattered ray (51);

      and
      c3) continuing (17) with step c1) for the next ray (33) ;
      and

   d) storing or outputting (14) the added up signal.

2. Method (10) according to claim 1, wherein in step b) the rays (33) are randomly selected.

3. Method (10) according to claim 2, wherein in step b) the rays (33) are randomly selected based on at least one random number and preferably based on two random numbers.

4. Method (10) according to claim 2 or 3, wherein in step b) the rays (33) are randomly selected by importance sampling, low discrepancy sampling patterns or deterministic sampling patterns.

5. Method (10) according to any preceding claim, wherein in step b) at least two, preferably at least 100, more preferably at least 500 and most preferably at least 1000 rays (33) are selected.

6. Method (10) according to any preceding claim, wherein in step b) at most 100000, preferably at most 10000, more preferably at most 5000 and most preferably at most 2000 rays (33) are selected.

7. Method (10) according to any preceding claim, wherein step c2) further comprises the following steps if an intersection is found:

   - calculating (16.2) an intersection time point $t_I$ based on a radiation time point $t_R$ of the current ray (33, 51) and on a length of the current ray (33, 51) from its origin to the intersection $s_I$; and
   - calculating (16.3) a sensing time point ts of sensing the reflected energy (52, 53) at the LIDAR sensor based on the intersection time point $t_I$ and on the length of a distance from the intersection to the LIDAR sensor $s_S$; wherein in the step of adding (16.4) the reflected energy, the reflected energy (52, 53) is added to the signal at the sensing time point ts.

8. Method (10) according to any preceding claim, wherein the step of determining a scattered ray (16.5) comprises reducing the current ray (33, 51) by the reflected energy (52, 53).

9. Method (10) according to any preceding claim, wherein each ray (33) represents a time varying energy distribution of a laser pulse contained in a vector of time bins and wherein the reflected energy (52, 53) represents a time varying energy distribution (40) corresponding to the energy of the laser pulse reflected from the object (50) at the intersection back over time contained in a vector (41) of time bins.

10. Method (10) according to any preceding claim, wherein the signal is distributed over time represented by a vector (42) of time bins, the vector (42) having a length corresponding to a (predetermined) sampling time $T_S$.

11. Method (10) according to any preceding claim, wherein the reflected energies (52, 53) of precedent beams (30) are accounted for in the present beam (30).

12. System (20) for simulating a LIght Detection And Ranging, LIDAR, beam (30) of a LIDAR sensor in a scene, configured for implementing the method (10) according to claim 1 and comprising:

   - a processing unit (21) having:

      - a discretising module (23) configured for discretising (11) a source area (31) of the LIDAR beam (30) into separate origins;
      - a selecting module (24) configured for selecting (12) rays (33) based on the origins;

- a ray-tracing module (25) configured for:

    - finding (15) an intersection of the current ray (33, 51) with an object (50) of the scene through ray-tracing for each ray (33);
    - determining (16.1) a reflected energy (52, 53) of the current ray (33, 51) that is reflected from the object (50) at the intersection back to the LIDAR sensor if an intersection is found;
    - adding (16.4) the reflected energy (52, 53) to a signal if an intersection is found;
    - determining (16.5) a scattered ray (51) based on the current ray (33, 51) scattered from the object (50) at the intersection if an intersection is found;
    - continuing (16.6) with finding (15) an intersection for the scattered ray (51); and
    - continuing (17) with finding (15) an intersection for the next ray (33);

and
- a storage (22) configured for storing (14) the added up signal or an output (22) configured for outputting (14) the added up signal.

13. System (20) according to claim 12 configured for implementing a method (10) according any of claims 2 to 11.

FIG 1

## FIG 2

## FIG 3

FIG 4

FIG 5

Europäisches
Patentamt

European
Patent Office

Office européen
des brevets

# EUROPEAN SEARCH REPORT

Application Number

EP 18 19 9899

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Angela M. Kim: "SIMULATING FULL-WAVEFORM LIDAR", Theses and Dissertations, 1 September 2010 (2010-09-01), XP055574612, Retrieved from the Internet: URL:https://calhoun.nps.edu/bitstream/handle/10945/4538/09Sep_Kim.pdf?sequence=1&isAllowed=y [retrieved on 2019-03-26] * pages 1,2 * * pages 42-46 * * pages 79-88 * | 1-13 | INV. G01S17/00 G06F17/50 |
| A | PETER SHIRLEY ET AL: "Monte Carlo techniques for direct lighting calculations", ACM TRANSACTIONS ON GRAPHICS (TOG), ACM, US, vol. 15, no. 1, 1 January 1996 (1996-01-01), pages 1-36, XP058303297, ISSN: 0730-0301, DOI: 10.1145/226150.226151 * abstract * | 4 | TECHNICAL FIELDS SEARCHED (IPC) G01S G06F |

The present search report has been drawn up for all claims

| Place of search | Date of completion of the search | Examiner |
|---|---|---|
| Munich | 27 March 2019 | Grübl, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)